# EUROPEAN PATENT APPLICATION

(11) **EP 3 633 733 A1**
(43) Date of publication of application: **08.04.2020**
(21) Application number: 18809350.4
(22) Date of filing: 12.04.2018
(51) Int. Cl.: H01L 29/739, H01L 29/12, H01L 29/78

(54) **SEMICONDUCTOR DEVICE**

(30) Priority: 29.05.2017 JP 2017105575
(71) Applicant: Hitachi Power Semiconductor Device, Ltd., Hitachi-shi, Ibaraki 319-1221 (JP)
(72) Inventor: MIYOSHI, Tomoyuki, Tokyo 100-8280 (JP); MORI, Mutsuhiro, Tokyo 100-8280 (JP); TAKEUCHI, Yujiro, Tokyo 100-8280 (JP); FURUKAWA, Tomoyasu, Tokyo 100-8280 (JP)
(74) Representative: Mewburn Ellis LLP
(86) International application number: PCT/JP2018/015330
(87) International publication number: WO 2018/221032

(57) **Abstract**

Provided is an IGBT capable of achieving both low conduction loss and low switching loss in the IGBT and achieving low power consumption, and a power conversion device to which the IGBT is applied. The semiconductor device includes a first conductivity type semiconductor layer formed on a first main surface of a semiconductor substrate, a second conductivity type well region formed on the first main surface side and in contact with the first conductivity type semiconductor layer, a first gate electrode and a second gate electrode adjacent to each other across the second conductivity type well region and in contact with the first conductivity type semiconductor layer and the second conductivity type well region through a gate insulating film, a first conductivity type emitter region formed on the first main surface side of the second conductivity type well region, a second conductivity type power supply region that penetrates the first conductivity type emitter region and is electrically connected to the second conductivity type well region, an emitter electrode electrically connected to the second conductivity type well region through the second conductivity type power supply region, a second conductivity type collector layer formed on a second main surface side of the semiconductor substrate that is opposite to the first main surface side and in contact with the first conductivity type semiconductor layer, and a collector electrode electrically connected to the second conductivity type collector layer. An interval between the first gate electrode and the second gate electrode is narrower than an interval between the first gate electrode and another adjacent gate electrode and an interval between the second gate electrode and another adjacent gate electrode. Each of the first gate electrode and the second gate electrode is electrically connected to any of a switching gate wiring and a carrier control gate wiring. The number of gate electrodes connected to the carrier control gate wiring is larger than the number of gate electrodes connected to the switching gate wiring.

## Description

### Technical Field

The present invention relates to a semiconductor device and a power conversion device using the same, and particularly relates to a technique effective for reducing power loss of an IGBT and increasing the efficiency of the power conversion device.

### Background Art

Global warming has become a main urgent issue common to the world and contribution expectation for power electronics technology is increasing as one of the countermeasures. In particular, in order to improve the efficiency of an inverter that has a power conversion function, there is a need to reduce power consumption of a power semiconductor device that mainly includes an Insulated Gate Bipolar Transistor (IGBT) that have a power switching function and a diode that has a rectification function.

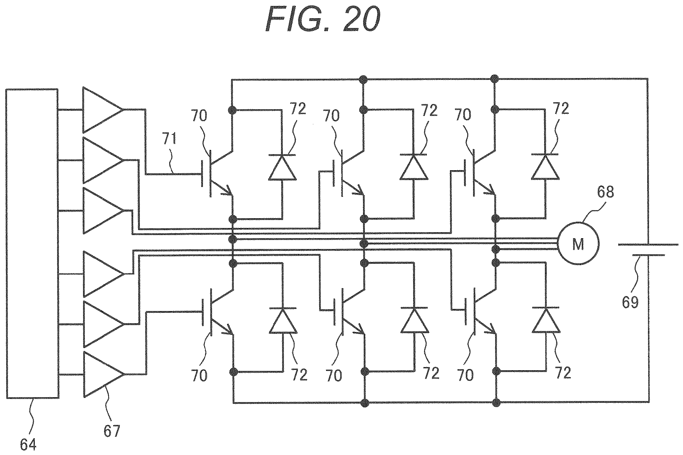

FIG. 20 shows a circuit diagram of a part of an inverter in the related art. A diode 72 is connected in antiparallel to an IGBT 70 in the IGBT 70 having an insulating gate terminal 71. The inverter is supplied with power from a DC voltage source 69 and controls power supplied to an inductive load 68 connected by applying a voltage to the insulating gate 71 of the IGBT 70 and repeating turn-on and turn-off at high speed. The inductive load 68 is, for example, a motor (an electric motor).

Since the IGBT 70 and the diode 72 cause conduction loss during conduction and cause switching loss during switching, it is necessary to reduce the conduction loss and the switching loss of the IGBT 70 and the diode 72 in order to reduce the size and increase the efficiency of the inverter. Here, the switching loss includes turn-on loss and turn-off loss caused by the IGBT and recovery loss caused by the diode during the turn-on.

As a technique for reducing the conduction loss and the turn-off loss of the IGBT, for example, a technique related to "an IGBT structure having two independently controllable gates" as described in PTLs 1 and 2 is known.

FIG. 21 is a cross-sectional view of an IGBT described in PTL 1. Gates G1 and G2 both have a trench shape. When a high voltage is applied to a gate electrode 91 of the gate G1 and a gate electrode 92 of the gate G2 with respect to an emitter electrode 7, an electron layer serving as an inversion layer is generated at a gate electrode interface of a p type well layer 2. As a result, when a forward voltage is applied between a collector electrode 8 and the emitter electrode 7, electron carriers are injected into an n- type drift layer 1 from the emitter electrode 7 through electron layers formed on surfaces of G1 and G2, hole carriers are extracted from a p type collector layer 4, conductivity modulation occurs inside the n- type drift layer 1, and the IGBT is in a conduction state.

At the time of turn-off, by applying to a gate a voltage less than a threshold voltage that does not form an inversion layer on the gate electrode interface of the p type well layer 2, carriers contributing to the conductivity modulation are discharged to the emitter electrode 7 and the collector electrode 8 and shifts to a non-conduction state. Due to a current generated at this time and a reverse voltage applied to the emitter electrode 7 and the collector electrode 8, power loss called turn-off loss occurs.

Here, in the above structure having two independently controllable gates, it is possible to apply a voltage less than the threshold voltage to the gate G2 prior to G1 immediately before turn-off and to temporarily form a drift region in which conductivity modulation is prevented. As a result, a current caused by the carriers discharged at the time of turn-off can be reduced and the turn-off loss can be reduced by applying the reverse voltage between the collector and the emitter at high speed. That is, this is a technique that can dynamically control a gate bias applied to G1 and G2 immediately before the conduction state and the non-conduction state and can reduce the loss caused at the time of turn-off by the control.

FIG. 22 is a cross-sectional view of an IGBT having two independently controllable gates described in PTL 2. In the structure, the p type well layer 2 is formed only on one side of each of the two gate electrodes G1 and G2, and a p type floating layer 93 is provided on an opposite electrode side. Further, an interval a between the gate electrodes 91 and 92 sandwiching the p type well layer 2 is shorter than an interval b sandwiching the p type floating layer 93. This is a structure aimed at promoting conductivity modulation and reducing conduction loss in an IGBT conduction state.

In the conduction state, electron carriers are injected from the emitter electrode 7 and hole carriers are injected from the p type collector layer 4 into the n- type drift layer 1, separately. Here, since the hole carrier has a current path that passes through the p type well layer 2 to the emitter electrode 7, it is necessary to increase the resistance of the path and make it difficult to remove the hole carrier in order to promote the conductivity modulation of the IGBT. Therefore, the above structure has a characteristic that a region of the p type well layer 2 is reduced compared to the structure of PTL 1, and an IGBT having a high accumulation effect of the hole carrier during conduction and a small conduction loss can be implemented.

### Related art Literature

### Patent Literature

PTL 1: JP-A-2016-134568
PTL 2: WO2014/038064

### Summary of Invention

### Technical Problem

In order to further reduce the loss in the IGBTs in the related art, it is effective to further improve the controllability of conductivity modulation in the drift region at the time of conduction and turn-off. That is, a structure is required to improve the accumulation effect of a carrier in order to promote conductivity modulation during conduction, and to improve the carrier extraction efficiency of the carrier in order to prevent conductivity modulation immediately before the turn-off.

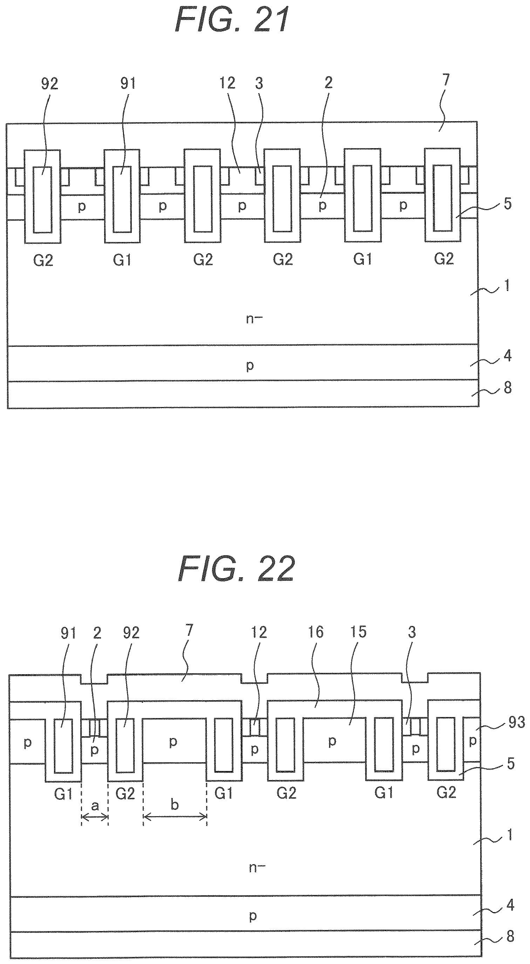

However, in the IGBT of FIG. 21, it is difficult to increase conductivity modulation during conduction and the IGBT of FIG. 22 has a poor effect of extracting the carrier immediately before the turn-off. It is difficult to further improve a tradeoff relationship between the IGBT conduction loss and the turn-off loss by the above structures.

An object of the invention is to provide an IGBT capable of achieving low conduction loss and low switching loss in the IGBT and achieving low power consumption, and a power conversion device to which the IGBT is applied.

### Solution to Problem

In order to solve the above problems, the invention provides a semiconductor device including: a first conductivity type semiconductor layer formed on a first main surface of a semiconductor substrate; a second conductivity type well region formed on the first main surface side and in contact with the first conductivity type semiconductor layer; a first gate electrode and a second gate electrode adjacent to each other across the second conductivity type well region and in contact with the first conductivity type semiconductor layer and the second conductivity type well region through a gate insulating film; a first conductivity type emitter region formed on the first main surface side of the second conductivity type well region; a second conductivity type power supply region that penetrates the first conductivity type emitter region and is electrically connected to the second conductivity type well region; an emitter electrode electrically connected to the second conductivity type well region through the second conductivity type power supply region; a second conductivity type collector layer formed on a second main surface side of the semiconductor substrate that is opposite to the first main surface side and in contact with the first conductivity type semiconductor layer; and a collector electrode electrically connected to the second conductivity type collector layer. An interval between the first gate electrode and the second gate electrode is narrower than an interval between the first gate electrode and another adjacent gate electrode and an interval between the second gate electrode and another adjacent gate electrode. Each of the first gate electrode and the second gate electrode is electrically connected to any of a switching gate wiring and a carrier control gate wiring. The number of gate electrodes connected to the carrier control gate wiring is larger than the number of gate electrodes connected to the switching gate wiring.

### Advantageous Effect

According to the invention, in the IGBT, by improving the controllability of conductivity modulation, a tradeoff relationship between an on-voltage and turn-off loss is improved, and both low conduction loss and low switching loss can be achieved.

As a result, it is possible to implement an IGBT capable of reducing power consumption and a power conversion device to which the IGBT is applied.

Problems, configurations, and effects other than those described above will be clarified by the description of the embodiments below.

### Brief Description of Drawings

[FIG. 1] FIG. 1 is a cross-sectional view of a semiconductor device according to a first embodiment of the invention.
[FIG. 2] FIG. 2 is a schematic diagram showing a carrier distribution in a conduction state of the IGBT, in which a voltage equal to or higher than a threshold voltage is applied to a GS gate and a GC gate in the semiconductor device according to the first embodiment of the invention.
[FIG. 3] FIG. 3 is a schematic diagram showing a carrier distribution in a conduction state of the IGBT, in which a voltage equal to or higher than a threshold voltage is applied to the GS gate, and a voltage lower than a threshold voltage is applied to the GC gate in the semiconductor device according to the first embodiment of the invention.
[FIG. 4] FIG. 4 is a diagram showing a driving waveform at the time of turn-off applied to the semiconductor device according to the first embodiment of the invention and a collector emitter voltage waveform, a collector current waveform, and a current and voltage product of the IGBT obtained thereby.
[FIG. 5] FIG. 5 is a diagram showing correlation between turn-off loss of the IGBT obtained by the invention and a channel number ratio generated by the GC gate with respect to the channel number generated by the GS gate.
[FIG. 6A] FIG. 6A is a cross-sectional view of a semiconductor device according to a second embodiment of the invention.
[FIG. 6B] FIG. 6B is a plan layout view of the semiconductor device according to the second embodiment of the invention.
[FIG. 7A] FIG. 7A is a cross-sectional view of a semiconductor device according to a modification of the second embodiment of the invention.
[FIG. 7B] FIG. 7B is a plan layout view of the semiconductor device according to the modification of the second embodiment of the invention.
[FIG. 8] FIG. 8 is a cross-sectional view of a semiconductor device according to a third embodiment of the invention.
[FIG. 9A] FIG. 9A is a diagram showing a feedback capacitance of the semiconductor device according to the first embodiment of the invention.
[FIG. 9B] FIG. 9B is a diagram showing a feedback capacitance of the semiconductor device according to the third embodiment of the invention.
[FIG. 10] FIG. 10 is a cross-sectional view of a semiconductor device according to a modification of the third embodiment of the invention.
[FIG. 11] FIG. 11 is a diagram showing a driving signal of a semiconductor device according to a fourth embodiment of the invention.
[FIG. 12] FIG. 12 is a diagram showing a driving signal of a semiconductor device according to a modification (a first modification) of the fourth embodiment of the invention.
[FIG. 13] FIG. 13 is a diagram showing the driving signal of the semiconductor device according to the modification (the first modification) of the fourth embodiment of the invention, and a collector emitter voltage waveform and a collector current waveform of an IGBT obtained thereby.
[FIG. 14] FIG. 14 is a diagram showing a driving signal of a semiconductor device according to another modification (a second modification) of the fourth embodiment of the invention.
[FIG. 15] FIG. 15 is a diagram showing the driving signal of the semiconductor device as another modification (the second modification) of the fourth embodiment of the invention, and a collector emitter voltage waveform and a collector current waveform of an IGBT obtained thereby.
[FIG. 16] FIG. 16 is a diagram showing a circuit configuration of a power conversion device according to a fifth embodiment of the invention.
[FIG. 17] FIG. 17 is a diagram showing a circuit configuration of a power conversion device according to a modification (a first modification) of the fifth embodiment of the invention.
[FIG. 18] FIG. 18 is a diagram showing a circuit configuration of a power conversion device according to another modification (a second modification) of the fifth embodiment of the invention.
[FIG. 19] FIG. 19 is a diagram showing a circuit configuration of a power conversion device according to another modification (a third modification) of the fifth embodiment of the invention.
[FIG. 20] FIG. 20 is a diagram showing a circuit configuration of a power conversion to which the related art is applied.
[FIG. 21] FIG. 21 is a cross-sectional view of a semiconductor device to which the related art disclosed in PTL 1 is applied.
[FIG. 22] FIG. 22 is a cross-sectional view of a semiconductor device to which the related art disclosed in PTL 2 is applied.

### Description of Embodiments

Embodiments of the invention will be described below with reference to the drawings. In the drawings, the same components are denoted by the same reference numerals, and detailed descriptions of repeated parts will be omitted. Notations "n-" and "n" in the drawings indicate that a semiconductor layer is of n type and impurity concentration is relatively high in this order. Similarly, notations "p-" and "p" indicate that a semiconductor layer is of p type and impurity concentration is relatively high in this order.

### First Embodiment

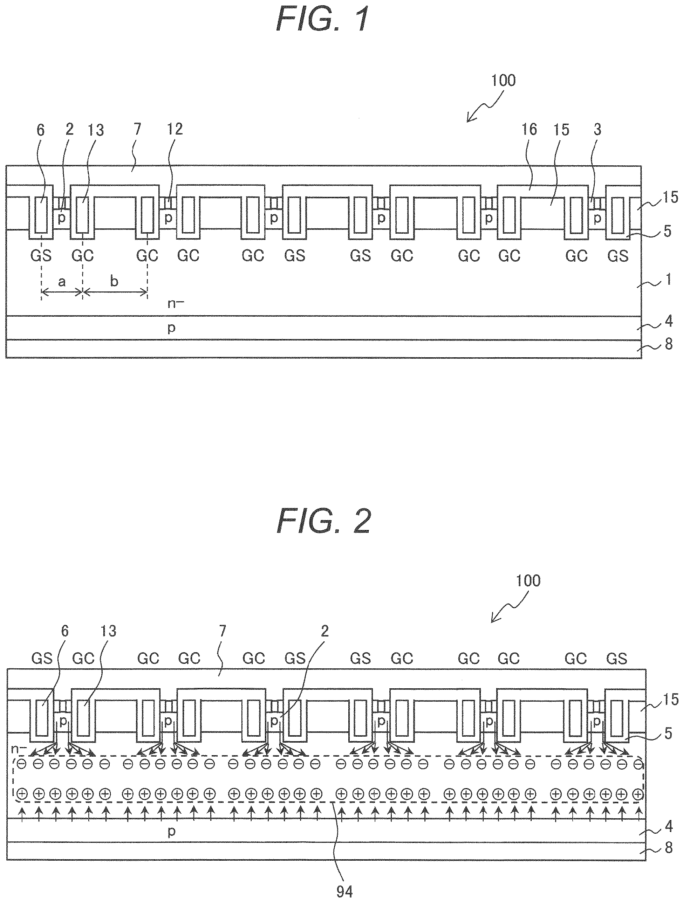

A semiconductor device (IGBT) 100 of an insulating gate type (gate control type) according to a first embodiment of the invention will be described with reference to FIGS. 1 to 5. FIG. 1 is a cross-sectional view of a part of the IGBT 100 according to the present embodiment.

As shown in FIG. 1, the present embodiment describes an IGBT having a trench gate shape and two independently controllable gates (GS, GC). The IGBT includes the p type well layer 2 vertically adjacent to the n- type drift layer 1 and the p type collector layer 4 vertically adjacent to the n- type drift layer 1 on the opposite side to the p type well layer 2. Further, a p type power supply layer 12 and the n type emitter layer 3 are adjacent to each other on an upper portion of the p type well layer 2. The p type well layer 2 and the n type emitter layer 3 are in contact with a first insulating gate (a GS gate) 6 of a trench gate type and a second insulating gate (a GC gate) 13 of a trench gate type each having a gate electrode through a gate insulating film (a gate oxide film) 5.

The emitter electrode 7 has a downward convex trench shape and is in contact with the p type power supply layer 12 and the n type emitter layer 3. The first insulating gate electrode (the GS gate) 6 and the second insulating gate electrode (the GC gate) 13 are electrically separated from each other through a thick insulating film 16. The emitter electrode 7 and the p type well layer 2 are electrically connected to each other through the p type power supply layer 12. Further, the collector electrode 8 is electrically connected to the p type collector layer 4. Further, a ratio of the number of GC gates 13 to the GS gate 6 is 1 or more. In FIG. 1 according to the present embodiment, the ratio is 2 (GS:GC = 1:2). Note that, the semiconductor layer used here is formed of silicon (Si) or silicon carbide (SiC) and the gate insulating film 5 is formed of silicon dioxide (SiO₂). A region in which the p type well layer 2, the GS gate 6, and the GC gate 13 are not formed between the n- type drift layer 1 and the emitter electrode 7 is the p type floating layer or an n-type drift layer 15.

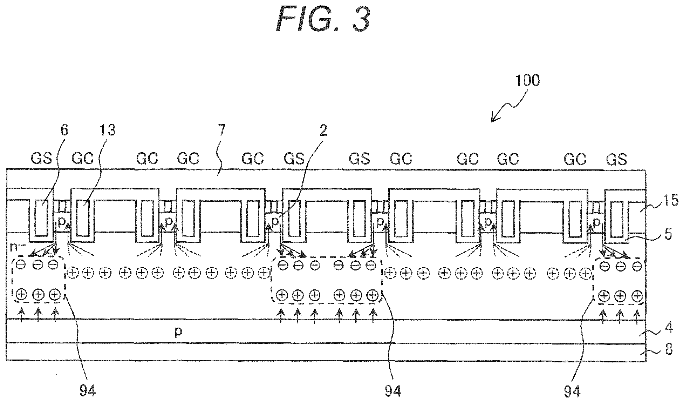

Next, operation of the semiconductor device (IGBT) 100 according to the present embodiment will be described with reference to FIGS. 2 and 3. FIG. 2 schematically shows distribution of electron carriers and hole carriers when a voltage for generating an electron layer that is an inversion layer in the p type well layer 2 is applied to the GS gate 6 and the GC gate 13 and when a forward voltage is applied between the collector electrode 8 and the emitter electrode 7. Here, the voltage applied to the GS gate 6 and the GC gate 13 is, for example, a positive voltage equal to or higher than a threshold voltage. The voltage causes inversion due to a gate voltage at the interface between the GS gate 6 as well as the GC gate 13 of the p type well layer 2 and the gate insulating film 5 that is in contact with 6 and 13, and a channel layer in which electrons are accumulated is formed.

Through the above channel layer, electrons are injected from the emitter electrode 7 into the n- type drift layer 1. In the n- type drift layer 1, holes are induced by the injected electrons and injected from the p type collector layer 4, so that conductivity modulation 94 occurs in the n- type drift layer 1 and the forward voltage of the IGBT decreases.

In the GS gate 6 and the GC gate 13, the p type well layer 2 is arranged only on one side plane and a p type layer or the n- type drift layer 15 having a floating potential is arranged on the other side plane. That is, one channel layer is formed with respect to one trench gate. As shown in FIG. 1, an interval a of gate electrodes on the side where the p type well layer 2 is arranged is shorter than an interval b of gate electrodes on the side where the p type well layer 2 is not arranged. (a < b) As a result, in a conduction state, a region of the p type well layer 2 serving as a current path to the emitter electrode 7 is narrow for the hole carriers injected from the p type collector layer 4. Since resistance of the region is high, the accumulation effect of the hole carriers is increased and the conductivity modulation effect of the IGBT can be promoted. Therefore, the conduction loss during IGBT conduction can be reduced by controlling the voltage to the semiconductor device (IGBT) 100, the GS gate 6, and the GC gate 13 having the present structure.

Next, operation when a voltage for forming a channel in the p type well layer 2 is applied to the GS gate 6 and a voltage less than a threshold voltage for not forming a channel in the p type well layer 2 is applied to the GC gate 13 is described using FIG. 3. Here, the voltage that does not form the channel in the p type well layer 2 is, for example, a negative voltage lower than the threshold voltage. By applying the above voltages, the channel is formed by an electron layer serving as an inversion layer at an interface of an insulating film of the p type well layer 2 in contact with the GS gate 6; on the other hand, an accumulation layer of holes is formed in the interface of the insulating film of the p type well layer 2 in contact with the GC gate 13.

When a forward voltage to conduct the collector electrode 8 and the emitter electrode 7 is applied in the above state, the electron carriers are injected from the emitter electrode 7 into the n- type drift layer 1 through the channel layer at the interface of the GS gate 6 and the hole carriers are extracted from the p type collector layer 4. On the other hand, a part of the hole carriers in the n- type drift layer 1 are discharged to the emitter electrode 7 through a hole accumulation layer at the interface of the GC gate 13. Therefore, both the GS gate 6 and the GC gate 13 can reduce hole carrier concentration of the n- type drift layer 1 as compared with a case where the voltage for forming the channel is applied to the p type well layer 2, and the conductivity modulation effect of the IGBT can be prevented. That is, the carrier concentration inside the IGBT can be controlled by controlling the voltage applied to the GC gate 13 in the conduction state of the IGBT.

Here, considering a turn-off operation in which the IGBT shifts from the conduction state to a non-conduction state, a change in the current and the voltage when shifting to the non-conduction state depends on the number of carriers that contributed to the conductivity modulation during conduction. Accordingly, the turn-off loss can be reduced by the structure capable of controlling the carrier concentration inside the IGBT and the voltage control. Then, in the present embodiment in which the number of channels generated by the voltage applied to the GC gate 13 is larger than the number of channels generated by the voltage applied to the GS gate 6, the controllability of the conductivity modulation by the voltage applied to the GC gate can be enhanced, so that it is possible to maintain a low conduction loss and reduce the turn-off loss.

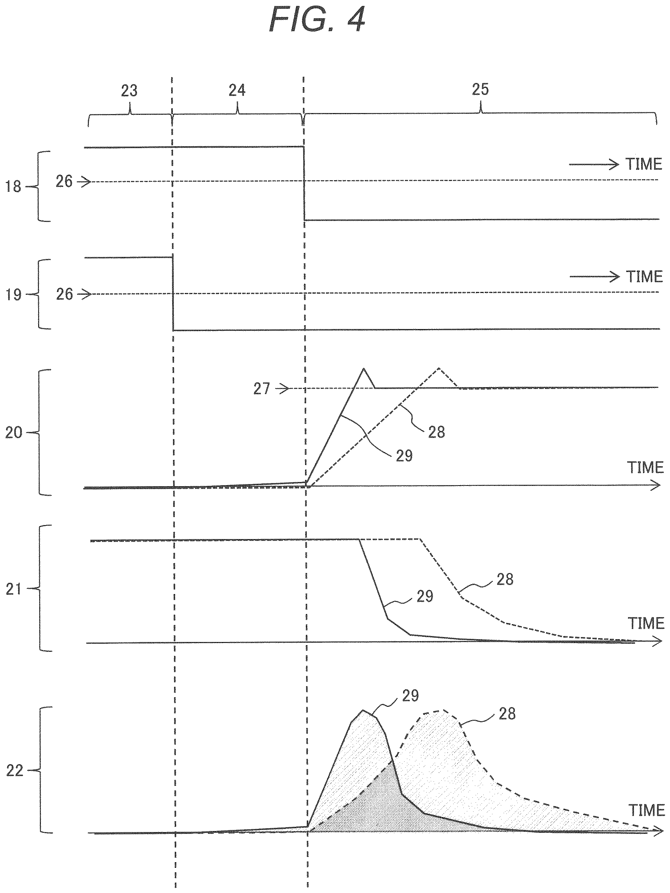

Next, the effect of the invention during conduction and turn-off will be described with reference to FIG. 4. In FIG. 4, a GS gate driving signal 18, a GC gate driving signal 19, a collector-emitter voltage waveform 20 of the IGBT, a collector current waveform 21 of the IGBT, and a current and voltage product 22 of the IGBT are arranged in order from the top. Here, solid lines 29 in the collector current waveform 21 of the IGBT, the collector-emitter voltage waveform 20 of the IGBT, and the current and voltage product 22 of the IGBT are waveforms obtained by the structure to which the first embodiment of the invention is applied. On the other hand, dotted lines 28 are waveforms obtained by an IGBT in the related art. In a conduction period 23 of the IGBT, a signal having a threshold voltage equal to or higher than the threshold voltage 26 is input to both the GS gate and the GC gate, the collector-emitter voltage 20 is low, and a low conduction loss performance can be implemented.

Next, in an immediately-before-turn-off period 24, the driving signal 19 of the GC gate is lowered to the threshold voltage 26 or less prior to the GS gate signal 18. As a result, the carrier concentration inside the IGBT is reduced, the conductivity modulation effect is prevented, and the collector-emitter voltage 20 temporarily increases.

Next, in a turn-off period 25, when the GS gate driving signal 18 falls below the threshold voltage 26, carrier injection of the IGBT is stopped, depletion progresses inside the IGBT due to the power supply voltage applied between the collector and emitter, the collector-emitter voltage 20 increases, the carriers are discharged, and the collector current 21 decreases.

Here, the solid line waveform 29 of the invention changes in a short time with respect to the dotted line waveform 28 in the related art, that is, high speed turn-off is performed. This is because the carrier concentration decreases by the voltage control of the GC gate in the immediately-before-turn-off period 24 and the depletion of the IGBT and the discharge of the carriers are performed at high speed. The power loss of the IGBT is derived by time integration of the current and voltage product 22, which indicates that the power loss can be reduced by high speed turn-off. That is, it is shown that the low conduction loss and the low turn-off loss can be achieved by the structure of the IGBT having two gates shown in the present embodiment and the control signals thereof.

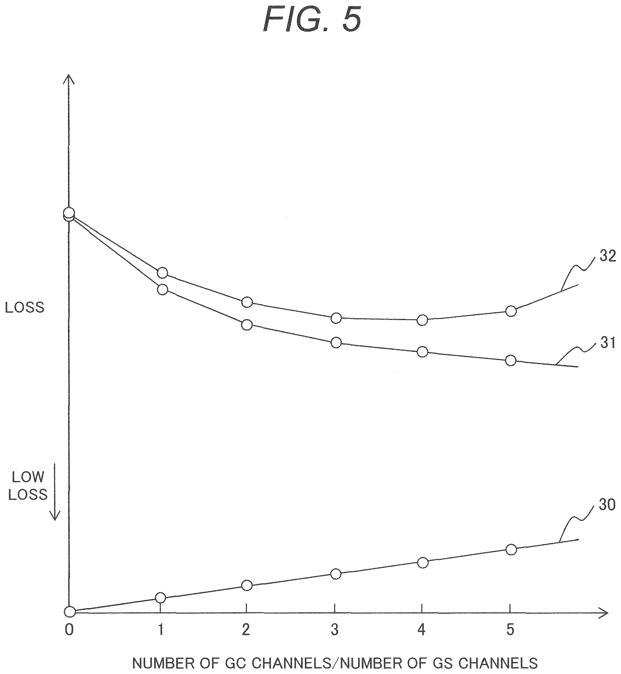

FIG. 5 shows correlation between the loss and the ratio of the number of channels formed by the voltage applied to the GC gate and the number of channels formed by the voltage applied to the GS gate. The figure shows a conduction-loss-rising amount 30 caused by applying a voltage less than the threshold voltage only to the GC gate 30 in the immediately-before-turn-off period 24, a turn-off switching loss 31 due to time change of voltage and current during the turn-off period 25, and correlation between a total turn-off loss 32 defined by a sum of the above loss and a ratio of the number of GC/GS channels.

As shown in FIG. 5, by increasing the ratio of the number of GC/GS channels, the temporary conduction loss rise due to the reduction of the carrier concentration tends to increase. On the other hand, the turn-off loss can be greatly reduced by increasing the switching speed. When the ratio of the number of GC/GS channels is larger than that in the related art, the total turn-off loss can be reduced most. That is, by applying the invention to the IGBT having two independent gates disclosed in PTLs 1 and 2, it is possible to derive a high loss reduction effect.

From the above, it is shown that by applying the invention to a dual gate type IBGT, it is possible to implement a low-loss IGBT that achieves both low conduction loss and low turn-off loss.

### Second Embodiment

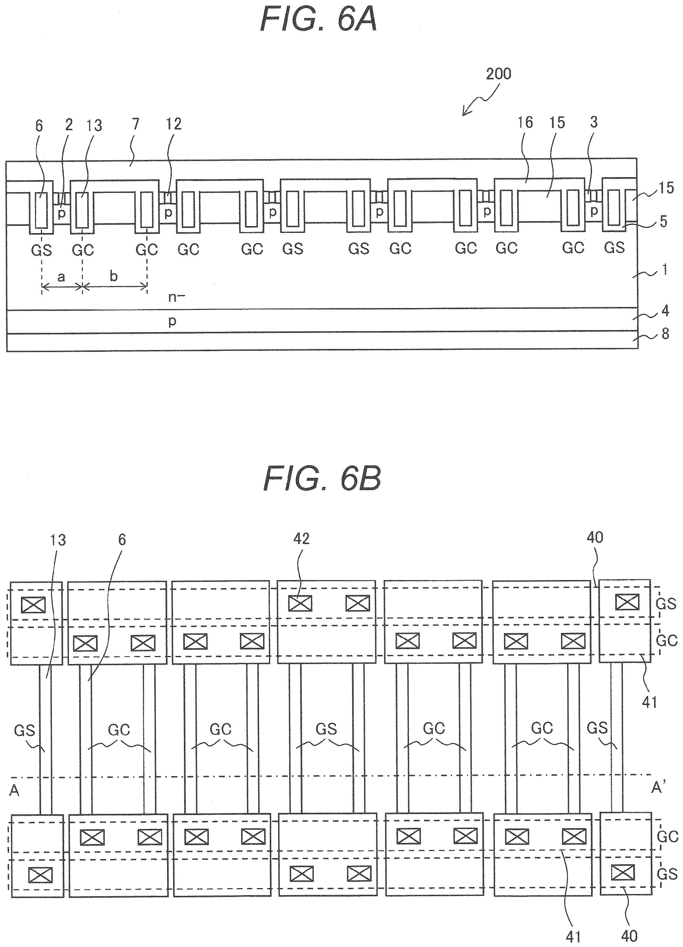

A semiconductor device (IGBT) 200 of an insulating gate type (a gate control type) according to a second embodiment of the invention will be described with reference to FIGS. 6A and 6B. FIG. 6A is a cross-sectional view of a part of the IGBT according to the present embodiment and FIG. 6B is a plan layout view of the IGBT according to the present embodiment. A cross section taken along a line A-A' in FIG. 6B corresponds to the cross-sectional view of FIG. 6A.

The present embodiment describes an IGBT having a trench gate shape and two independently controllable gates. The IGBT includes the p type well layer 2 vertically adjacent to the n- type drift layer 1 and the p type collector layer 4 vertically adjacent to the n- type drift layer 1 on the opposite side to the p type well layer 2. Further, the p type power supply layer 12 and the n type emitter layer 3 are adjacent to each other on an upper portion of the p type well layer 2. The p type well 2 and the n type emitter layer 3 are in contact with the first insulating gate (GS gate) 6 of a trench gate type and the second insulating gate (GC gate) 13 of a trench gate type each having a gate electrode through the gate insulating film (the gate oxide film) 5.

The emitter electrode 7 has a downward convex trench shape and is in contact with the p type power supply layer 12 and the n type emitter layer 3. The first insulating gate electrode (GS gate) 6 and the second insulating gate electrode (GC gate) 13 are electrically separated from each other through the thick insulating film 16. The emitter electrode 7 and the p type well layer 2 are electrically connected to each other through the p type power supply layer 12. Further, the collector electrode 8 is electrically connected to the p type collector layer 4. Further, a ratio of the number of GC gates 13 to the GS gate 6 is 1 or more. In FIG. 6A according to the present embodiment, the ratio is 2 (GS: GC = 1:2). Note that, the semiconductor layer used here is formed of silicon (Si) or silicon carbide (SiC), and the gate insulating film 5 is formed of silicon dioxide (SiO₂). A region in which the p type well layer 2, the GS gate 6, and the GC gate 13 are not formed between the n- type drift layer 1 and the emitter electrode 7 is the p type floating layer or the n- type drift layer 15.

The present embodiment has a characteristic that the GS gate 6 and the GC gate 13 sandwiching the p type well layer 2 are controllable independently of each other. As shown in the plan view of FIG. 6B, the two gates 6 and 13 are separately connected to a GS gate wiring 40 and a GC gate wiring 41 which are two gate wirings which can respectively introduce independent electrical signals. Here, each gate wiring and each gate electrode are connected through a contact layer 42 and a plurality of gate electrodes are bundled with gate wirings through the contact layer 42. Input signals given to the GS gate wiring 40 and the GC gate wiring 41 are transmitted respectively to each gate electrode.

Here, a location where the contact layer 42 is located is a terminal end portion of an active region where the IGBT operation occurs. When the contact layer 42 at the terminal end portion overlaps with the GS gate wiring 40, a GS signal can be sent to the gate electrode. On the other hand, when the contact layer 42 overlaps with the GC gate wiring 41, the GC signal can be sent to the gate electrode. That is, according to the present embodiment of the invention, it is possible to select which of the functions of GC and GS is used for the gate electrode by arrangement of the contact layer 42.

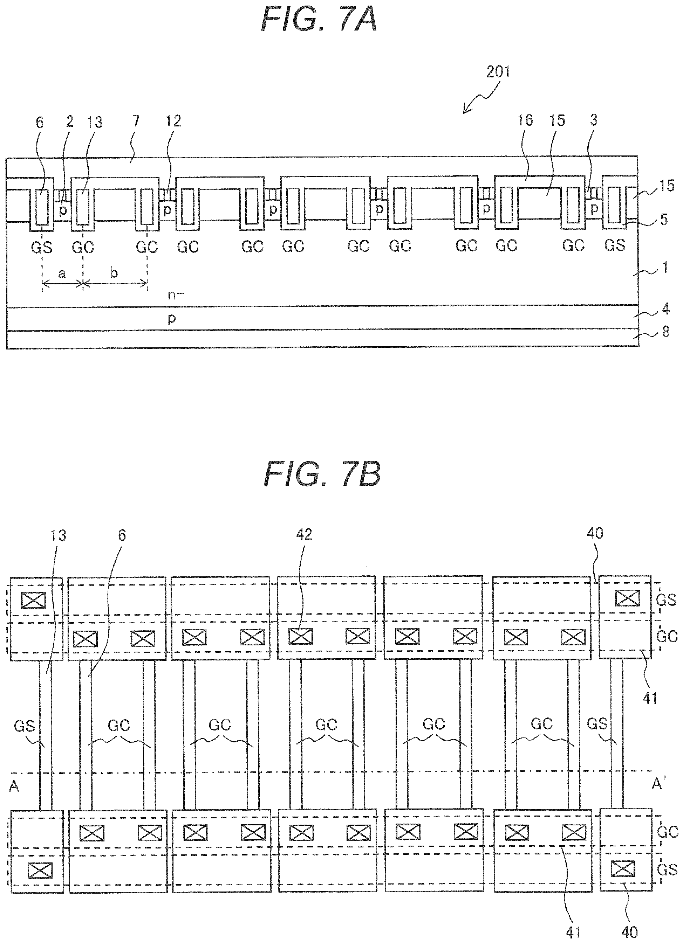

A modification of the present embodiment will be described with reference to FIGS. 7A and 7B. FIGS. 7A and 7B show an example in which a ratio of the number of channels formed by applying a voltage to the GS gate 6 and the GC gate 13 is changed by the arrangement of the contact layer 42. FIG. 7A is a cross-sectional view of an IGBT 201 according to the present modification and FIG. 7B is a plan layout view of the IGBT 201 according to the present modification. A cross section taken along a line A-A' in FIG. 7B corresponds to the cross-sectional view of FIG. 7A.

In the structure, two contact layers 42 arranged at the center in FIG. 7B overlap with the GC gate wiring 41. As a result, the gate electrode at the center portion has the function of the GC gate 6. As shown in FIG. 7A, the ratio of the number of channels formed by applying a voltage to the GS gate 6 and the GC gate 13 (the ratio of the number of GC/GS channels) can be increased with respect to the structure shown in FIG. 6A. As described above, according to the invention, by adjusting the arrangement of the contact layers, the ratio of the number of channels by GS and the number of channels by GC can be arbitrarily adjusted.

As described in FIG. 5, the ratio of the number of GS and GC channels is important as an adjustment parameter for reducing the IGBT turn-off loss, and an optimum ratio varies depending on the dimension, such as the thickness in the depth direction of the n- type drift layer 1, and impurity concentration of various IGBT structures. Therefore, according to the invention, it is possible to provide an optimum IGBT structure that achieves both low conduction loss and low turn-off loss and can implement the optimal channel number ratio that can extract the effect of preventing conductivity modulation due to the bias applied to the GC while maintaining low conduction loss.

### Third Embodiment

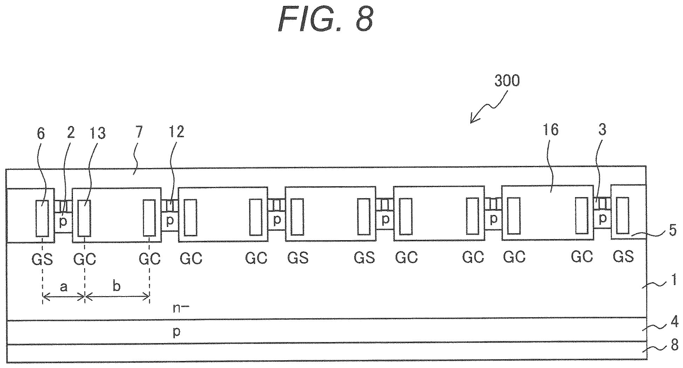

A semiconductor device (IGBT) 300 of an insulating gate type (a gate control type) according to a third embodiment of the invention will be described with reference to FIGS. 8 to 9B. FIG. 8 is a cross-sectional view of the IGBT 300 according to the present embodiment.

The present embodiment relates to an IGBT having a side gate shape in which a gate electrode is arranged only on a side wall with respect to a trench. The IGBT has two independently controllable gates and includes the p type well layer 2 vertically adjacent to the n- type drift layer 1 and the p type collector layer 4 vertically adjacent to the n- type drift layer 1 on the opposite side to the p type well layer 2. Further, the p type power supply layer 12 and the n type emitter layer 3 are adjacent to each other on an upper portion of the p type well layer 2. The p type well layer 2 and the n type emitter layer 3 are in contact with the first insulating gate (the GS gate) 6 of a side gate type and the second insulating gate (the GC gate) 13 of a side gate type each having a gate electrode through the gate insulating film (the gate oxide film) 5.

The emitter electrode 7 has a downward convex trench shape and is in contact with the p type power supply layer 12 and the n type emitter layer 3. The first insulating gate electrode (the GS gate) 6 and the second insulating gate electrode (the GC gate) 13 are electrically separated from each other through the thick insulating film 16. The emitter electrode 7 and the p type well layer 2 are electrically connected to each other through the p type power supply layer 12. Further, the collector electrode 8 is electrically connected to the p type collector layer 4. Further, a ratio of the number of GC gates 13 to the GS gate 6 is 1 or more. In FIG. 8 according to the present embodiment, the ratio is 2 (GS:GC = 1:2). Note that, the semiconductor layer used here is formed of silicon (Si) or silicon carbide (SiC) and the gate insulating film 5 is formed of silicon dioxide (SiO₂).

Further, in the GS gate 6 and the GC gate 13 according to the present embodiment, the p type well layer 2 is formed only on one side plane and the other side plane is constituted by a side gate shape in which the thick insulating film 16 is arranged. That is, one channel layer is formed for one side gate. Further, an interval a of gate electrodes on the side where the p type well layer 2 is arranged is shorter than an interval b of gate electrodes on the side where the p type well layer 2 is not arranged. (a < b) As a result, in a conduction state, a region of the p type well layer 2 serving as a current path to the emitter electrode 7 is narrow for the hole carriers injected from the p type collector layer 4. Since resistance of the portion is high, the accumulation effect of the hole carriers is increased and the conductivity modulation effect of the IGBT can be promoted. Therefore, the conduction loss during IGBT conduction can be reduced by controlling the voltage to the semiconductor device (IGBT) 300, the GS gate 6, and the GC gate 13 having the present structure.

According to the present embodiment, it is possible to further reduce the switching loss at the time of turn-off or turn-on as compared with the IGBT 100 described in the first embodiment. This is because feedback capacity that exists parasitically between the IGBT collector and gate is reduced by the side gate shape.

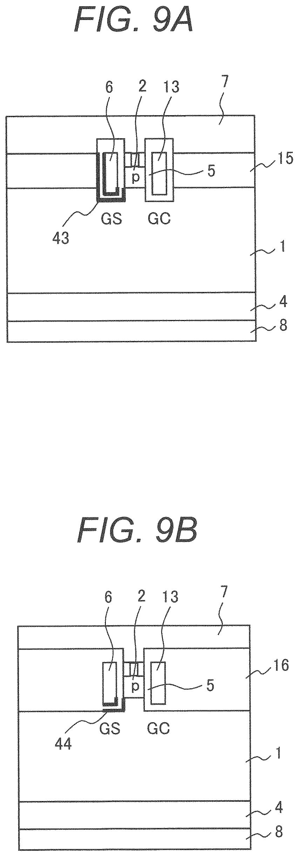

FIGS. 9A and 9B show cross-sections of the trench gate type IGBT and the side gate type IGBT in the first and third embodiments, respectively, and feedback capacitance corresponding thereto. In the trench gate type shown in FIG. 9A, in addition to MOS capacitance formed by the gate electrode (the GS gate 6), the gate insulating film 5 and the n- type drift layer 1 at the lower portion of the trench gate, MOS capacitance formed by a plane facing the p type well layer 2, that is, the p type floating layer or the n type drift layer 15, the gate insulating film 5, and the GS gate 6 is arranged in parallel.

As a result, when a feedback capacitance 43 of the trench gate type IGBT is large and the IGBT is turn-off switched or turn-on switched, a mirror period for charging the capacitance is generated, which prevents a change in the high-speed current and voltage and increases the loss.

On the other hand, in the side gate type of FIG. 9B, the thick insulating film 16 is arranged in a plane facing the p type well layer 2 and no capacitive component exists. Therefore, a feedback capacitance 44 is formed only of the MOS capacitance formed by the gate electrode (the GS gate 6), the gate insulating film 5, and the n- type drift layer 1 in the lower portion of the side gate, and a capacitance value thereof is smaller than that of the trench gate type. Therefore, when the switching is performed to the trench gate type, changes in current and voltage at a higher speed occurs and the loss is reduced.

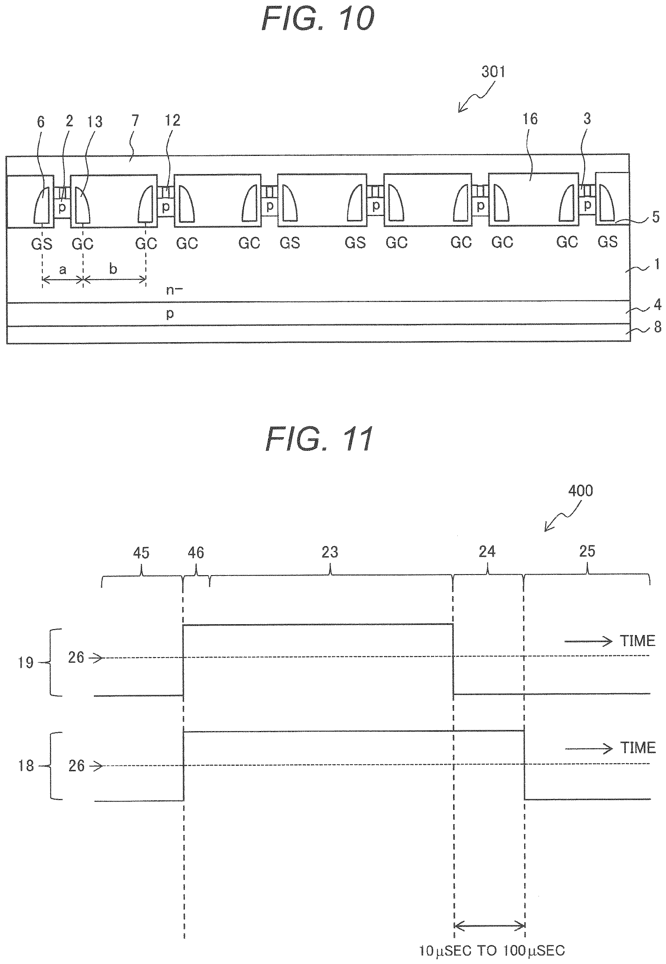

A modification of the present embodiment will be described with reference to FIG. 10. FIG. 10 shows an IGBT 301 including the GS gate 6 and the GC gate 13 each having a sidewall shape. Due to limitations of a semiconductor manufacturing process, the side gate type IGBT structure is implemented by the GS gate 6 and the GC gate 13 each having such a sidewall shape, and a feature of a small feedback capacitance can be extracted.

From the above, according to the present embodiment, it is possible to further improve the effect of the low turn-off loss shown in the first embodiment, and to implement an IGBT having high efficiency with further reduced conduction loss and turn-off loss.

### Fourth Embodiment

A driving signal (a control method) of a semiconductor device of an insulating gate type (a gate control type) according to a fourth embodiment of the invention will be described with reference to FIG. 11. Here, a target semiconductor device is an IGBT having two independently controllable gates shown in the first to third embodiments of the invention.

In a non-conduction period 45, both the GS gate driving signal 18 and the GC gate driving signal 19 are less than the threshold voltage 26, no channel is formed, and a high voltage is applied between a collector and an emitter. Next, in a turn-on period 46, a voltage equal to or higher than the threshold voltage 26 is applied to both the GS gate driving signal 18 and the GC gate driving signal 19 to form a channel. As a result, the IGBT is in a conduction state. In the conduction period 23, a state in which the voltage applied to the GS gate 18 and the GC gate 19 is equal to or higher than the threshold voltage 26 is continued. The conductivity modulation of the IGBT is promoted and a low conduction loss is implemented.

Next, in the immediately-before-turn-off period 24, only the GC gate driving signal 19 is applied with a voltage less than the threshold voltage 26. As a result, the channel by the GC gate 19 disappears, hole carriers in a drift region are extracted to the emitter through the generated accumulation layer, and the carrier concentration of the drift region is temporarily decreased. The period (the immediately-before-turn-off period 24) is preferably 10 µsec to 100 µsec. Next, in the turn-off period 25, a voltage less than the threshold voltage 26 is also applied to the GS gate 18 and the IGBT shifts to the non-conduction state. Here, the collector-emitter voltage rises and the current decreases at high speed due to the effect that the carrier concentration is reduced immediately before this period, and the effect of reducing the turn-off loss can be derived.

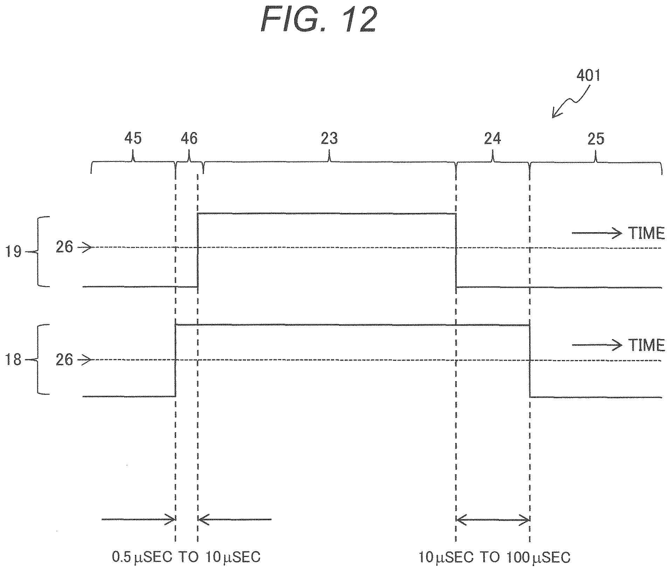

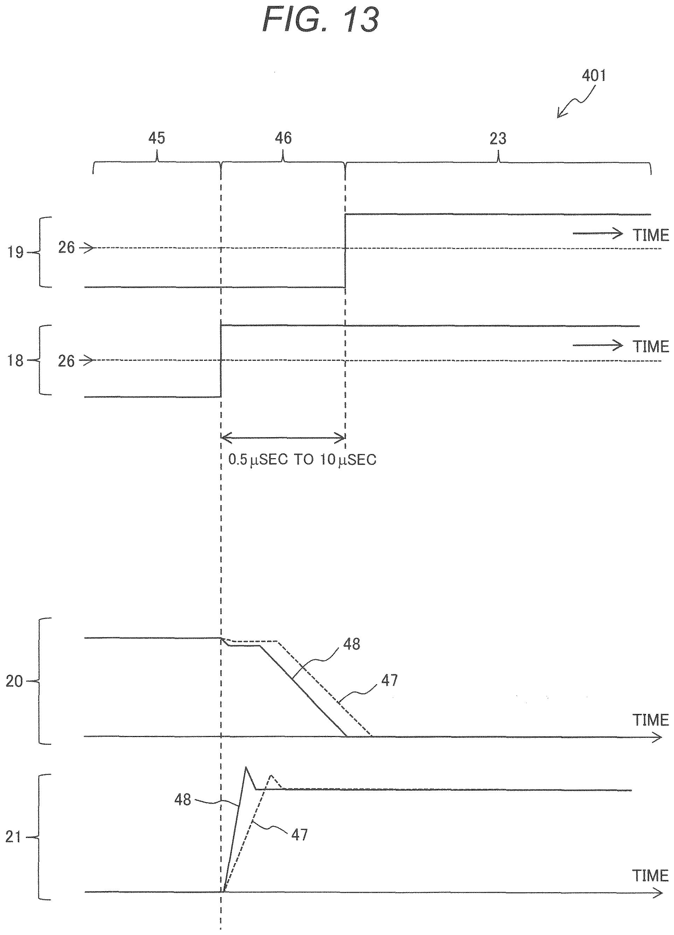

Next, a first modification of the present embodiment (the fourth embodiment of the invention) will be described with reference to FIGS. 12 and 13. Also in this case, the target semiconductor device is an IGBT having two independently controllable gates shown in the first to third embodiments of the invention.

In the present modification, as shown in FIG. 12, in the non-conduction period 45, both the GS gate driving signal 18 and the GC gate driving signal 19 are equal to or lower than the threshold voltage 26, no channel is formed, and a high voltage is applied between the collector and the emitter. Next, in the turn-on period 46, a voltage equal to or higher than the threshold voltage 26 is applied prior to the GS gate 18. As a result, although a channel is formed only on the GS gate side and the IGBT is in the conduction state, transconductance (gm) of the IGBT can be turned on in a low state as compared with the case where the GC and the GS are simultaneously set to the threshold voltage 26 or more. As a result, time change dv/dt of the collector-emitter voltage generated by turn-on can be reduced and it is possible to deal with problems such as inductive noise and motor insulation which are problems in application of power modules due to dv/dt.

In the turn-on driving in which the GS gate 18 and the GC gate 19 shown in FIG. 11 are simultaneously set to the threshold voltage 26 or more, a resistance is required to be connected to the gate of the IGBT for the dv/dt control, which causes a side effect that it is difficult to reduce the change in the collector current of the IGBT di/dt and the turn-on loss is increased.

FIG. 13 shows a time change of the collector emitter voltage waveform 20 and the collector current waveform 21 by the turn-on driving in which the GS gate 18 and the GC gate 19 are simultaneously set to the threshold voltage 26 or more and the turn-on driving shown in FIG. 12 in which the GS gate 18 is set to the threshold voltage 26 or more prior to the GC gate 19. A dotted line in the figure is a waveform 47 generated by the former driving, and a solid line in the figure is a waveform 48 generated by the latter driving.

As in the first modification of the present embodiment (FIG. 12), the dv/dt can be maintained and the di/dt can be increased by the turn-on driving in which the GS gate 18 is set to the threshold voltage 26 or more prior to the GC gate 19, thereby reducing the turn-on loss. It is desirable that the time of the turn-on period 46 is 0.5 µsec to 10 µsec. In addition, the driving method in the conduction period 23, the immediately-before-turn-off period 24, and the turn-off period 25 is the same as that in FIG. 12, so that low conduction loss and low turn-off loss can be simultaneously obtained.

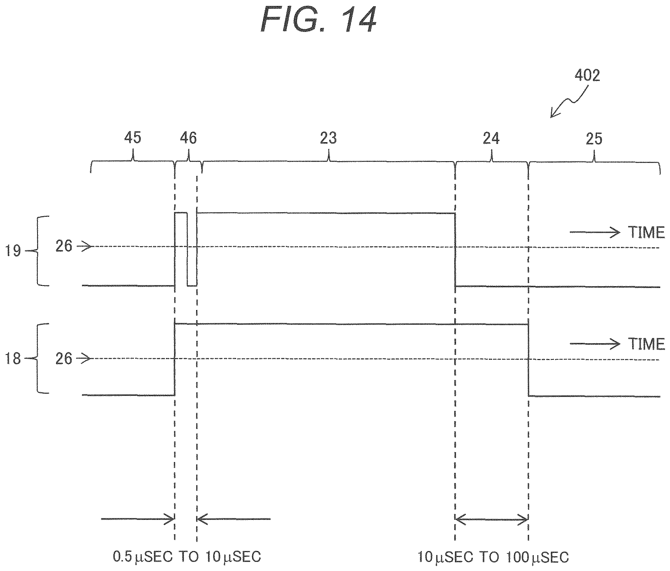

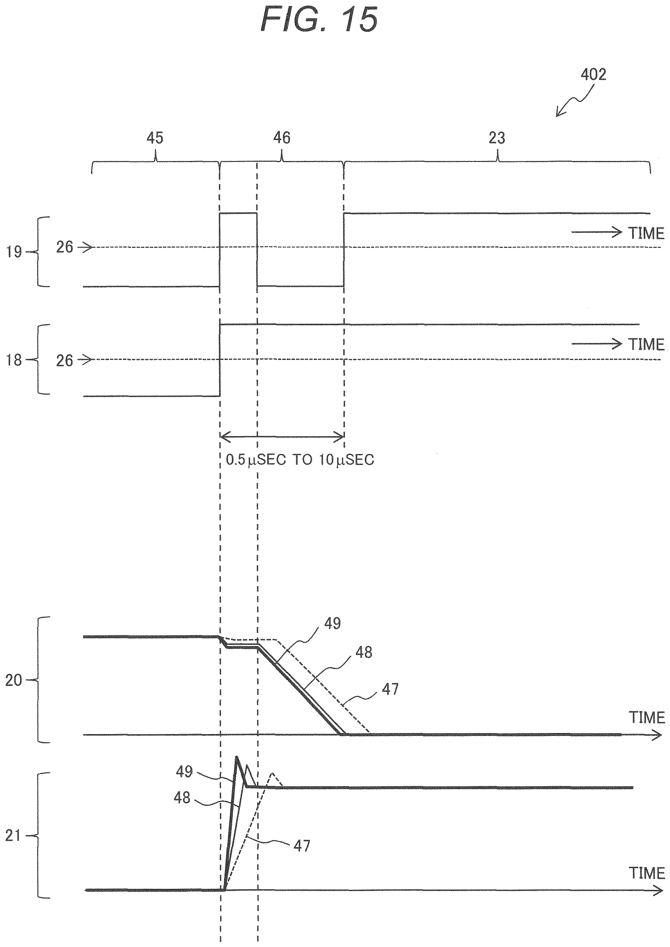

Next, a second modification of the present embodiment (the fourth embodiment of the invention) will be described with reference to FIGS. 14 and 15. Also in this case, the target semiconductor device is an IGBT having two independently controllable gates shown in the first to third embodiments of the invention.

In the present modification, as shown in FIG. 14, in the non-conduction period 45, both the GS gate driving signal 18 and the GC gate driving signal 19 are less than the threshold voltage 26, no channel is formed, and a high voltage is applied between the collector and the emitter. Next, in the turn-on period 46, first, a voltage equal to or higher than the threshold voltage 26 is simultaneously applied to the GS gate 18 and the GC gate 19. Next, only the GC gate 19 is once dropped below the threshold voltage 26, and then the GC gate 19 is again set to the threshold voltage 26 or more.

The timing will be described in detail with reference to FIG. 15. First, in the turn-on period 46, a voltage equal to or higher than the threshold voltage 26 is simultaneously applied to the GS gate 18 and the GC gate 19, whereby a channel is formed by GS and GC, carriers are injected into the IGBT, and a collector current flows. When the collector current waveform 21 is constant, the collector-emitter voltage waveform 20 starts to decrease. At this moment, only the driving signal 19 of the GC gate is once dropped below the threshold voltage 26. After the collector-emitter voltage 20 is sufficiently lowered and stabilized in the vicinity of an on-voltage of the IGBT, the GC gate driving signal 19 is set to the threshold voltage 26 or more again. The effects of the control are as follows.

In a period in which the collector current 21 rises and di/dt rises, the channel is generated on both sides of the GS gate 18 and the GC gate 19 to increase the injection efficiency of the carriers, thereby increasing di/dt. On the other hand, in a period in which the voltage decreases and dv/dt rises, a channel is only generated on one side of the GS gate 18 for injecting the carrier, thereby reducing the transconductance (gm) of the IGBT and implementing a suitably prevented dv/dt.

FIG. 15 shows time change of the collector-emitter voltage waveform 20 and the collector current waveform 21 when applying turn-on driving in which the GS gate driving signal 18 and the GC gate driving signal 19 shown in FIG. 11 are simultaneously set to be equal to or higher than the threshold voltage 26, turn-on driving in which the GS gate driving signal 18 is set to be equal to or higher than the threshold voltage 26 prior to the GC gate driving signal 19 shown in FIG. 12, and turn-on driving in which the GC gate driving signal 19 is once dropped below the threshold voltage 26 after the GS gate driving signal 18 and the GC gate driving signal 19 shown in FIG. 14 are simultaneously set to be equal to or higher than the threshold voltage 26 and then the GC gate driving signal 19 is once again raised to be equal to or higher than the threshold voltage 26. A dotted line in FIG. 15 is the turn-on waveform 47 generated by the driving of FIG. 11, a thin solid line is the turn-on waveform 48 generated by the driving of FIG. 12, and a thick solid line is a turn-on waveform 49 generated by the driving of FIG. 14.

By providing a period in which the GS gate 18 is set to be equal to or higher than the threshold voltage 26 prior to the GC gate 19, the dv/dt can be adjusted to an appropriate value. Further, during a period in which the collector current 21 changes, di/dt can be maximized by applying a voltage equal to or higher than the threshold voltage 26 to both the GS gate 18 and the GC gate 19.

As a result, it is possible to reduce the turn-on loss. It is desirable that the time of the turn-on period 46 is 0.5 µsec to 10 µsec. In addition, the driving method in the conduction period 23, the immediately-before-turn-off period 24, and the turn-off period 25 is the same as that in FIG. 11, so that low conduction loss and low turn-off loss can be simultaneously obtained.

From the above, by applying the invention, it is shown that an IGBT having low turn-on loss in addition to the low conduction loss and the low turn-off loss can be implemented.

### Fifth Embodiment

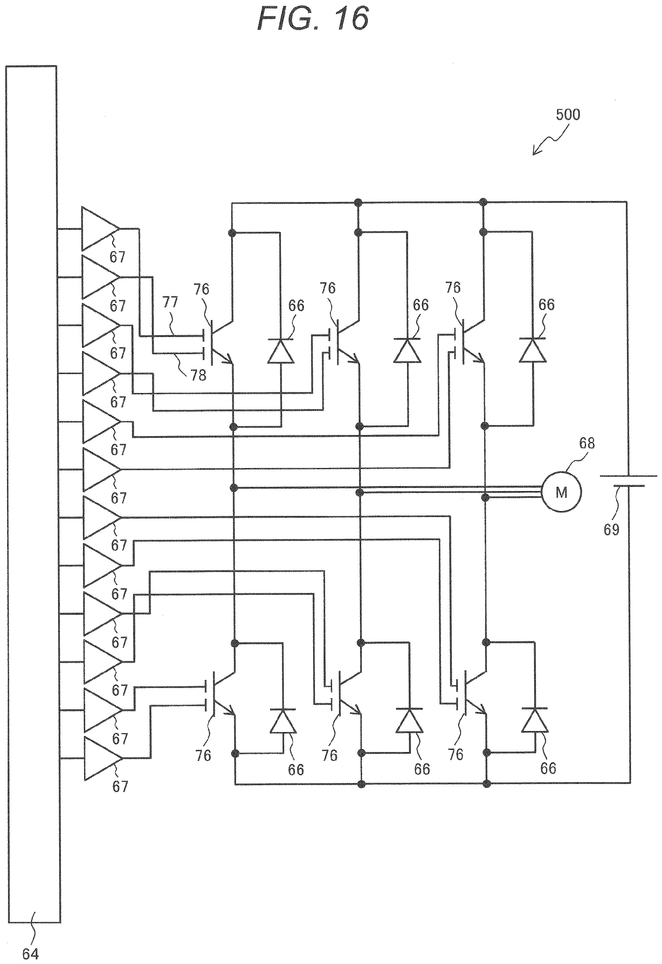

A power conversion device 500 according to a fifth embodiment of the invention will be described with reference to FIG. 16. As shown in FIG. 16, the power conversion device 500 according to the present embodiment includes an IGBT 76 of upper and lower arms in accordance with an IGBT command signal from a control circuit 64 and a driving circuit 67 that drives a diode 66.

Here, the IGBT 76 is a semiconductor device (the IGBTs 100, 200, 201, 300, 301) having two independently controllable GS gate terminal 77 and GC gate terminal 78 as shown in the first to fourth embodiments of the invention.

The driving circuit 67 is mainly a level shift circuit that converts an input from the control circuit 64 into an input signal of an IGBT gate. The power conversion device (a driving device) 500 according to the present embodiment is an inverter that drives an inductive load 68 mainly including a motor, and has a function of converting a DC voltage (power) 69 into a three-phase AC voltage (power) of a U phase, a V phase, and a W phase and transmitting the three-phase AC voltage (power) to the inductive load 68.

The control circuit 64 has a function of generating a timing signal for driving the inductive load 68 and generating a timing signal for transmitting an optimum driving voltage to the GS gate terminal 77 and the GC gate terminal 78 in order to achieve a low loss performance of the IGBT. In addition, the invention is applied to all of the IGBTs 76 of the upper and lower arms in the present embodiment. According to the low loss performance of the IGBT according to the invention shown in the first to fourth embodiments, it is possible to implement a highly efficient power conversion device having a low power loss.

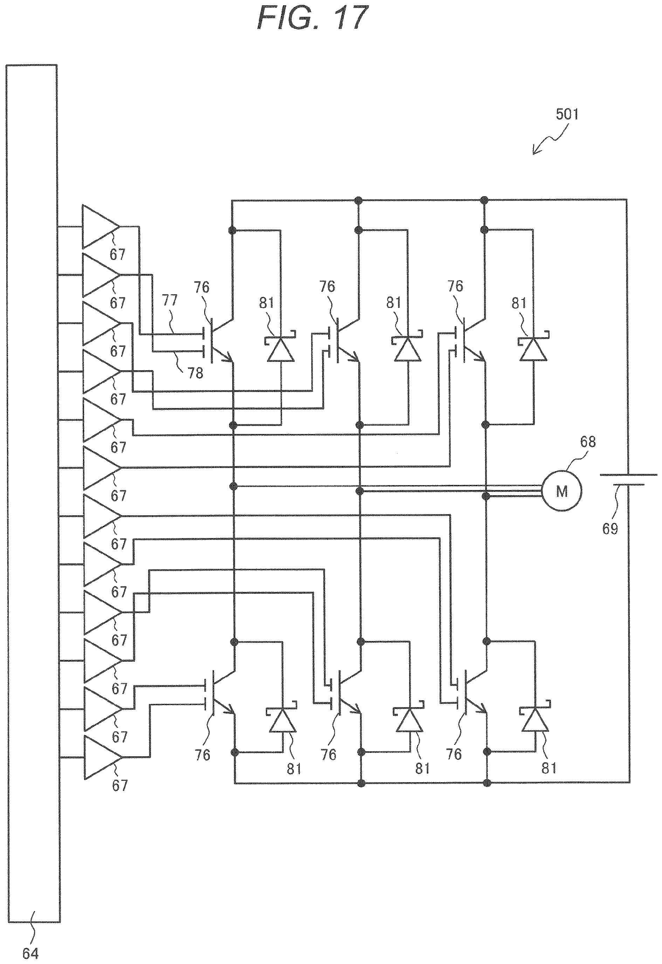

Next, a first modification of the present embodiment (the fifth embodiment of the invention) will be described with reference to FIG. 17. A power conversion device 501 according to the present modification is an example in which a Schottky barrier diode 81 mainly formed of SiC crystal is applied to a diode. Further, in the present modification, the power conversion device 501 includes the IGBT 76 of upper and lower arms in accordance with the IGBT command signal from the control circuit 64 and the driving circuit 67 that drives the Schottky barrier diode 81.

Here, the IGBT 76 is a semiconductor device (the IGBTs 100, 200, 201, 300, 301) having two independently controllable GS gate terminal 77 and GC gate terminal 78 as shown in the first to fourth embodiments of the invention.

The driving circuit 67 is mainly a level shift circuit that converts an input from the control circuit 64 into an input signal of an IGBT gate. The power conversion device (a driving device) 501 according to the present modification is an inverter that drives the inductive load 68 mainly including a motor, and has a function of converting the DC voltage (power) 69 into a three-phase AC voltage (power) of a U phase, a V phase, and a W phase and transmitting the three-phase AC voltage (power) to the inductive load 68.

The control circuit 64 has a function of generating a timing signal for driving the inductive load 68 and generating a timing signal for transmitting an optimum driving voltage to the GS gate terminal 77 and the GC gate terminal 78 in order to achieve a low loss performance of the IGBT. In addition, the invention is applied to all of the IGBTs 76 of the upper and lower arms in the present embodiment. Further, the Schottky barrier diode 81 is applied to all diodes of the upper and lower arms. According to the low loss performance of the IGBT according to the invention shown in the first to fourth embodiments and low switching loss performance of the Schottky barrier diode mainly formed of the SiC crystal, it is possible to implement a highly efficient power conversion device having low power loss.

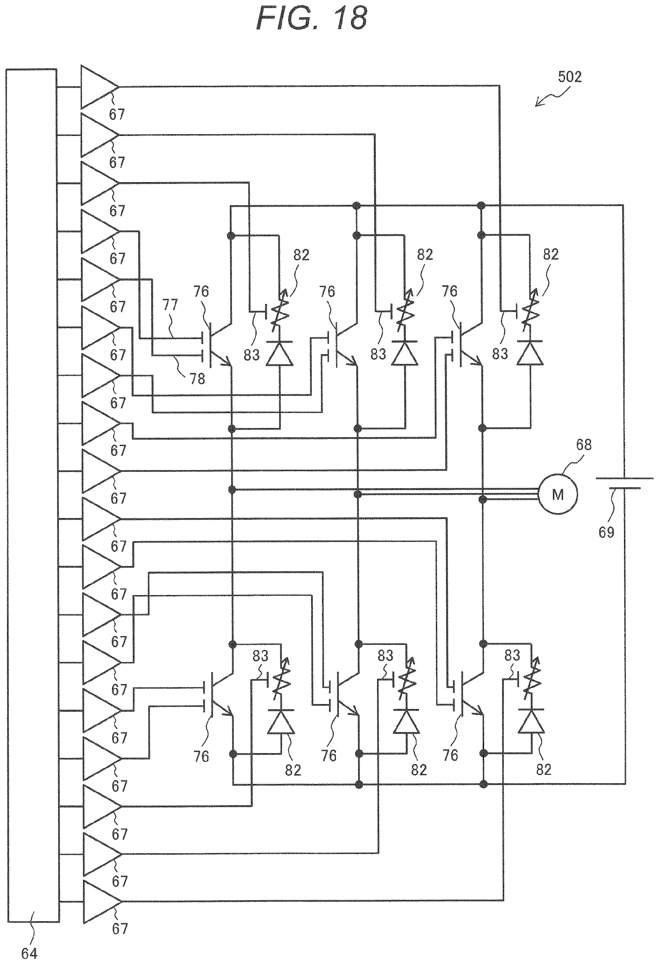

A second modification of the present embodiment (the fifth embodiment of the invention) will be described with reference to FIG. 18. A power conversion device 502 according to the present modification is an example in which an insulating gate control type diode 82 capable of dynamically controlling carrier concentration during conduction and switching is applied to a diode.

The power conversion device 502 includes the IGBT 76 of upper and lower arms in accordance with an IGBT command signal from the control circuit 64 and the driving circuit 67 that drives the insulating gate control type diode 82.

Here, the IGBT 76 is a semiconductor device (the IGBTs 100, 200, 201, 300, 301) having two independently controllable GS gate terminal 77 and GC gate terminal 78 shown in the first to fourth embodiments of the invention.

The driving circuit 67 is mainly a level shift circuit that converts an input from the control circuit 64 into an input signal of an IGBT gate. The power conversion device (driving device) 502 according to the present modification is an inverter that drives the inductive load 68 mainly including a motor, and has a function of converting the DC voltage (power) 69 into a three-phase AC voltage (power) of a U phase, a V phase, and a W phase and transmitting the three-phase AC voltage (power) to the inductive load 68.

The control circuit 64 has a function of generating a timing signal for driving the inductive load 68 and generating a timing signal for transmitting an optimum driving voltage to the GS gate terminal 77 and the GC gate terminal 78 in order to achieve low loss performance of the IGBT. Further, in order to achieve low loss performance of the insulating gate type diode, the control circuit 64 also has a function of generating a timing signal for transmitting an optimum driving voltage to an insulating gate terminal 83 of the diode.

In addition, the invention is applied to all of the IGBTs 76 of the upper and lower arms in the present embodiment. The insulating gate control type diode 82 is applied to all diodes of the upper and lower arms. According to the low loss performance of the IGBT according to the invention shown in the first to fourth embodiments and low switching loss performance by the insulating gate control type diode, it is possible to implement a highly efficient power conversion device having low power loss.

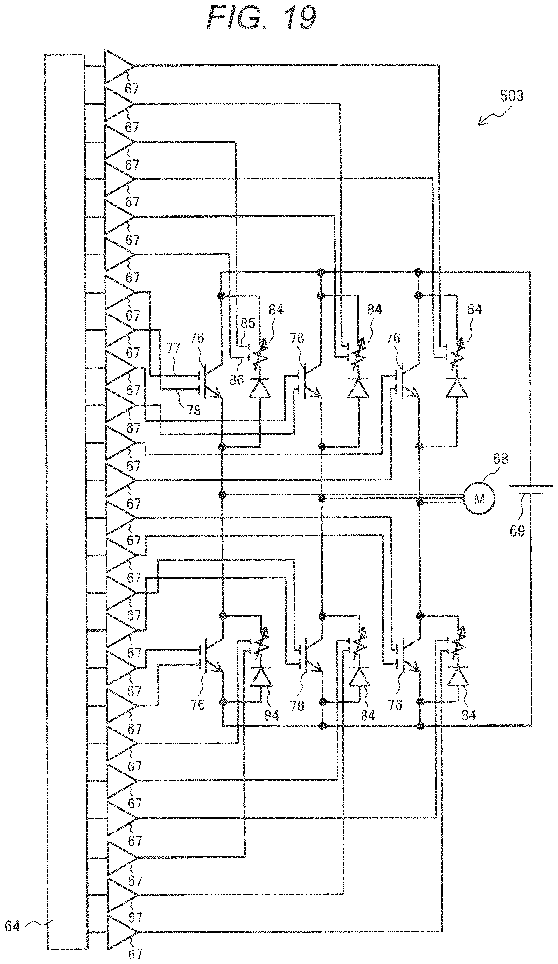

A third modification of the present embodiment (the fifth embodiment of the invention) will be described with reference to FIG. 19. A power conversion device 503 according to the present modification is an example in which an insulating gate control type diode 84 including two insulating gates capable of dynamically controlling carrier concentration during conduction and switching is applied to a diode.

The power conversion device 503 includes the IGBT 76 of the upper and lower arms in accordance with an IGBT command signal from the control circuit 64 and the driving circuit 67 that drives the insulating gate control type diode 84 including two insulating gates.

Here, the IGBT 76 is a semiconductor device (the IGBTs 100, 200, 201, 300, 301) having two GS gate terminal 77 and GC gate terminal 78 capable of independent control shown in the first to fourth embodiments of the invention.

The driving circuit 67 is mainly a level shift circuit that converts an input from the control circuit 64 into an input signal of an IGBT gate. The power conversion device (a driving device) 503 according to the present modification is an inverter that drives the inductive load 68 mainly including a motor, and has a function of converting the DC voltage (power) 69 into a three-phase AC voltage (power) of a U phase, a V phase, and a W phase and transmitting the three-phase AC voltage (power) to the inductive load 68.

The control circuit 64 has a function of generating a timing signal for driving the inductive load 68 and generating a timing signal for transmitting an optimum driving voltage to the GS gate terminal 77 and the GC gate terminal 78 in order to achieve low loss performance of the IGBT. Further, in order to achieve low loss performance of the insulating gate type diode 84 including the two insulating gates, the control circuit 64 also has a function of generating a timing signal for transmitting an optimum driving voltage to two insulating gate terminals (a first insulating gate terminal 85 and a second insulating gate terminal 86) of the diode.

In addition, the invention is applied to all of the IGBTs 76 of the upper and lower arms in the present embodiment. The insulating gate control type diode including two insulating gates is applied to all diodes of the upper and lower arms. According to the low loss performance of the IGBT according to the invention shown in the first to fourth embodiments and low switching loss performance by the insulating gate control type diode including two insulating gates, it is possible to implement a highly efficient power conversion device having low power loss.

The invention can be applied to a semiconductor device suitable for a wide range of applications from low-power devices such as air conditioners and microwave ovens to high-power devices such as inverters in automobiles, railways and steelworks, a semiconductor circuit driving device, and a power conversion device.

The invention is not limited to the embodiments described above and includes various modifications. For example, the above-mentioned examples are described in detail for easy understanding of the invention and the invention is not necessarily limited to those including all the configurations described above . A part of the configuration of one embodiment can be replaced with the configuration of another embodiment and the configuration of another embodiment can be added to the configuration of the one embodiment. In addition, a part of the configuration of the embodiment may be added, deleted, or replaced with another configuration.

Further, the invention also has the following features.
[Appendix 1]
   A semiconductor device control method, wherein
   a semiconductor device is a dual gate type IGBT including a switching gate electrode and a carrier control gate electrode that can be controlled independently of each other,
   an interval between the switching gate electrode and the carrier control gate electrode is narrower than an interval between the switching gate electrode or the carrier control gate electrode and other adjacent gate electrodes, and the number of the carrier control gate electrodes is larger than the number of the switching gate electrodes,
   when being driven, the dual gate type IGBT has:
   (a) a first state in which a voltage equal to or higher than a threshold voltage is applied to both the switching gate electrode and the carrier control gate electrode;
   (b) a second state in which a voltage equal to or higher than the threshold voltage is applied to the switching gate electrode, and a voltage lower than the threshold is applied to the carrier control gate electrode; and
   (c) a third state in which a voltage lower than a threshold voltage is applied to both the switching gate electrode and the carrier control gate electrode.
[Appendix 2]
   The semiconductor device control method according to appendix 1, wherein
   the dual gate type IGBT shifts in an order of (a), (b), and (c) when shifting from a conduction state to a non-conduction state.
[Appendix 3]
   The semiconductor device control method according to appendix 1, wherein
   the dual gate type IGBT shifts in an order of (c), (b), and (a) when shifting from a non-conduction state to a conduction state.
[Appendix 4]
   The semiconductor device control method according to appendix 1, wherein
   the dual gate type IGBT shifts in an order of (c), (a), (b), and (a) when shifting from a non-conduction state to a conduction state.
[Appendix 5]
   The semiconductor device control method according to any of appendixes 1 to 4, wherein
   when the dual gate type IGBT shifts from a conduction state to a non-conduction state, time required for (b) is 10 µsec or more.
[Appendix 6]
   The semiconductor device control method according to any of appendix 1 to 5, wherein
   when the dual gate type IGBT shifts from a non-conduction state to a conduction state, time required for (b) is 0.5 µsec or more.
[Appendix 7]
   A power conversion device comprising:
   an IGBT serving as a switching element;
   a diode connected in antiparallel to the IGBT and serving as a rectification element;
   a control circuit that outputs an IGBT driving signal; and
   a driving circuit that converts a driving signal from the control circuit into an input signal to a gate of the IGBT, wherein
   the IGBT uses the semiconductor device according to any one of claims 1 to 10 described in CLAIMS.
[Appendix 8]
   The power conversion device according to appendix 7, wherein
   the diode is a Schottky barrier diode using silicon carbide as a semiconductor substrate.
[Appendix 9]
   The power conversion device according to appendix 7, wherein
   the diode is an insulating gate control type diode capable of dynamically controlling carriers therein.

### Reference Sign List

1 n- type drift layer
2 p type well layer
3 n type emitter layer
4 p type collector layer
5 gate insulating film (oxide film)
6 insulating gate electrode GS (GS gate)
7 emitter electrode
8 collector electrode
12 p type power supply layer
13 insulating gate electrode GC (GC gate)
15 p type floating layer or n type drift layer
16 thick insulating film
18 GS gate (driving signal)
19 GC gate (driving signal)
20 IGBT collector-emitter voltage (waveform)
21 IGBT collector current (waveform)
22 current and voltage product of IGBT
23 (IGBT) conduction period
24 immediately-before-turn-off period
25 turn-off period
26 threshold voltage (forming inversion layer in p type well layer 2)
27 power supply voltage
28 IGBT in the related art
29 IGBT to which a first embodiment of the invention is applied
30 conduction-loss-rising amount (in immediately-before-turn-off period)
31 turn-off switching loss (in turn-off period 25)
32 total turn-off loss
40 GS gate wiring
41 GC gate wiring
42 contact layer
43 feedback capacitance (of trench gate type IGBT)
44 feedback capacitance (of side gate type IGBT)
45 non-conduction period
46 turn-on period
47 IGBT waveform to which a fourth embodiment of the invention (FIG. 11) is applied
48 IGBT waveform to which a first modification of the fourth embodiment of the invention (FIG. 12) is applied
49 IGBT waveform to which a second modification of the fourth embodiment of the invention (FIG. 14) is applied
64 control circuit
66 diode
67 driving circuit (driving IGBT)
68 inductive load
69 DC voltage (power) source
70 IGBT
71 insulating gate (terminal) of IGBT 70
72 diode (in antiparallel to IGBT 70)
76 IGBT (of the invention)
77 GS gate terminal (of IGBT 76 of the invention)
78 GC gate terminal (of IGBT 76 of the invention)
81 Schottky barrier diode
82 insulating gate control type diode
83 insulating gate terminal (of insulating gate control type diode)
84 insulating gate control type diode (constituted by two insulating gates)
85 first insulating gate terminal (of insulating gate control type diode constituted by two insulating gates)
86 second insulating gate terminal (of insulating gate control type diode constituted by two insulating gates)
91 gate electrode (insulating gate electrode G1)
92 gate electrode (insulating gate electrode G2)
93 p type floating layer
94 conductivity modulation
100 IGBT (of the first embodiment of the invention)
200 IGBT (of the second embodiment of the invention)
201 IGBT (of a modification of the second embodiment of the invention)
300 IGBT (of the third embodiment of the invention)
301 IGBT (of a modification of the third embodiment of the invention)
400 driving method of IGBT (of the fourth embodiment of the invention)
401 driving method of IGBT (of a first modification of the fourth embodiment of the invention)
402 driving method of IGBT (of a second modification of the fourth embodiment of the invention)
500 power conversion device (of the fifth embodiment of the invention)
501 power conversion device (of the first modification of the fifth embodiment of the invention)
502 power conversion device (of the second modification of the fifth embodiment of the invention)
503 power conversion device (of the third modification of the fifth embodiment of the invention)

## Claims

1. A semiconductor device comprising:
a first conductivity type semiconductor layer formed on a first main surface of a semiconductor substrate;
a second conductivity type well region formed on the first main surface side and in contact with the first conductivity type semiconductor layer;
a first gate electrode and a second gate electrode adjacent to each other across the second conductivity type well region and in contact with the first conductivity type semiconductor layer and the second conductivity type well region through a gate insulating film;
a first conductivity type emitter region formed on the first main surface side of the second conductivity type well region;
a second conductivity type power supply region that penetrates the first conductivity type emitter region and is electrically connected to the second conductivity type well region;
an emitter electrode electrically connected to the second conductivity type well region through the second conductivity type power supply region;
a second conductivity type collector layer formed on a second main surface side of the semiconductor substrate that is opposite to the first main surface side and in contact with the first conductivity type semiconductor layer; and
a collector electrode electrically connected to the second conductivity type collector layer, wherein
an interval between the first gate electrode and the second gate electrode is narrower than an interval between the first gate electrode and another adjacent gate electrode and an interval between the second gate electrode and another adjacent gate electrode,
each of the first gate electrode and the second gate electrode is electrically connected to any of a switching gate wiring and a carrier control gate wiring, and
the number of gate electrodes connected to the carrier control gate wiring is larger than the number of gate electrodes connected to the switching gate wiring.

2. The semiconductor device according to claim 1, wherein
the first gate electrode and the second gate electrode are trench gate type gate electrodes provided in a trench formed through the second conductivity type well region.

3. The semiconductor device according to claim 1, wherein
the first gate electrode and the second gate electrode are side gate type gate electrodes having no conduction region between the first gate electrode or the second gate electrode and other adjacent gate electrodes.

4. The semiconductor device according to claim 3, wherein
the first gate electrode and the second gate electrode are sidewall gate type gate electrodes having a sidewall shape that increases in width from the emitter electrode side toward the collector electrode side.

5. The semiconductor device according to any one of claims 1 to 4, wherein
the first gate electrode and the second gate electrode can be controlled independently of each other,
when being driven, the semiconductor device has:
(a) a first state in which a voltage equal to or higher than a threshold voltage is applied to both a gate electrode connected to the switching gate wiring and a gate electrode connected to the carrier control gate wiring;
(b) a second state in which a voltage equal to or higher than a threshold voltage is applied to the gate electrode connected to the switching gate wiring, and a voltage lower than the threshold voltage is applied to the gate electrode connected to the carrier control gate wiring; and
(c) a third state in which a voltage lower than a threshold voltage is applied to both the gate electrode connected to the switching gate wiring and the gate electrode connected to the carrier control gate wiring.

6. The semiconductor device according to claim 5, wherein
the semiconductor device shifts in an order of the (a), (b), and (c) when shifting from a conduction state to a non-conduction state.

7. The semiconductor device according to claim 5, wherein
the semiconductor device shifts in an order of the (c), (b), and (a) when shifting from a non-conduction state to a conduction state.

8. The semiconductor device according to claim 5, wherein
the semiconductor device shifts in an order of the (c), (a), (b), and (a) when shifting from a non-conduction state to a conduction state.

9. The semiconductor device according to any one of claims 5 to 8, wherein
when the semiconductor device shifts from a conduction state to a non-conduction state, time required for the (b) is 10 µsec or more.

10. The semiconductor device according to any one of claims 5 to 9, wherein
when the semiconductor device shifts from a non-conduction state to a conduction state, time required for the (b) is 0.5 µsec or more.
